# EUROPÄISCHE PATENTANMELDUNG

(11) **EP 1 253 642 A2**
(43) Veröffentlichungstag der Anmeldung: **30.10.2002**
(21) Anmeldenummer: 02009615.2
(22) Anmeldetag: 26.04.2002
(51) Int. Cl.: H01L 23/58

(54) **Halbleiterbauelement und dessen Herstellungsverfahren**

(30) Priorität: 26.04.2001 DE 10120520
(71) Anmelder: Infineon Technologies AG, 81669 München (DE)
(72) Erfinder: Leuschner, Rainer, Nohegan Lake, N. Y. 10547 (US); Lippmann, Bernhard, 84079 Bruckberg (DE); Schmid, Günter, 91334 Hemhofen (DE); Wallstab, Stefan, 81739 München (DE)
(74) Vertreter: Epping Hermann & Fischer

(57) **Zusammenfassung**

Ein ohmscher Widerstand ist zwischen zwei Anteilen einer Leiterschicht vorhanden, so dass die Größe des ohmschen Widerstandes ermittelt werden kann, und/oder in oder auf einer Schicht aus dem Dielektrikum (1) ist ein Halbleiterbereich (2) vorhanden, wobei die Leiterschicht (5) in einen Gate-Kontakt (6), einen Source-Kontakt (7) und einen Drain-Kontakt (70) strukturiert ist, so dass in dem Halbleiterbereich eine Transistor- oder Schaltfunktion möglich ist. Damit kann ein Versuch einer Analyse der in dem Chip integrierten Schaltung detektiert werden.

## Beschreibung

Die vorliegende Erfindung betrifft ein Halbleiterbauelement mit einer verbesserten Absicherung gegen unerwünschte Analyse, unsachgemäßen Eingriff und unbefugte Benutzung oder Nachbau sowie ein Herstellungsverfahren für dieses Bauelement.

Halbleiterbauelemente sind üblicherweise in einem Halbleiterchip integriert, der ein Substrat oder einen Halbleiterkörper mit einer darauf aufgebrachten Schichtstruktur aufweist. Diese Schichtstruktur umfasst üblicherweise epitaktisch auf dem Substrat abgeschiedene Halbleiterschichten mit den darin ausgebildeten aktiven Bauelementen einer integrierten Schaltung sowie eine darauf aufgebrachte mehrlagige Schichtstruktur, die eine oder mehrere zu Leiterbahnen und Kontakten strukturierte Metallschichten aufweist, die durch Zwischenmetalldielektrika voneinander getrennt und isoliert sind. Aktive Bauelemente und Strukturen, wie z. B. die Bestandteile eines Transistors, sind auf den Bereich des Halbleitermaterials beziehungsweise der Halbleiterschichtstruktur beschränkt. Die Metallisierungen und Leiterbahnebenen dienen der elektrischen Verbindung der einzelnen Anschlüsse der Bauelemente, die in ihrer Gesamtheit die integrierte Schaltung bilden.

Das Halbleitermaterial der integrierten Schaltung bildet daher für gewöhnlich einen zusammenhängenden Chipkörper, auf dessen Oberseite die elektrischen Anschlüsse sowie die Verdrahtung vorhanden sind. Als Abdeckung werden meistens eine einebnende Passivierung und eine elektrisch isolierende Umhüllmasse als Gehäuse verwendet. In dem abdeckenden Teil des Halbleiterchips sind keine aktiven Bauelemente vorhanden.

Beim so genannten Reverse-Engineering wird der Aufbau einer integrierten Schaltung analysiert, indem die interne Struktur des Halbleiterchips durch geeignete Untersuchungsmethoden aufgedeckt wird. Dazu sind in der Regel abdeckende Schichten, Gehäuse und Passivierungen zu entfernen. Wenn das Reverse-Engineering verhindert werden soll, weil die integrierte Schaltung geheim gehalten werden soll, müssen geeignete Mittel vorgesehen sein, die eine Analyse der Schaltung unmöglich machen oder zumindest stark erschweren.

Solche Mittel sind z. B. Abdeckungen des Halbleiterchips, die sich nicht ohne wesentliche Zerstörung der integrierten Schaltung entfernen lassen. Besonders vorteilhaft sind Abdeckungen mit darin integrierten Bestandteilen, die aktive Komponenten der Schaltung veranlassen, eine bestimmte Art von Zerstörung oder Veränderung der Schaltung zu bewirken, falls Manipulationen an den Bestandteilen der Abdeckung festgestellt werden. Die Schaltungskomponenten solcher aktiv funktionierender Schutzschirme sind Bestandteil der in dem Halbleiterchip integrierten Schaltung.

Das Problem, eine unerwünschte Analyse der in einem Halbleiterchip integrierten Schaltung zu verhindern, stellt sich speziell bei Smartcard-Prozessoren in Chipkarten sowie bei sonstigen sicherheitskritischen ICs. Wenn die Schaltung bekannt ist, können die Chips mit diesen Prozessoren so nachgebaut werden, dass sie die gewünschte Funktion freischalten, ohne dabei die auf diese Weise erbrachte Leistung zu verrechnen. Für einen Chipkarten-Hersteller ist es daher wichtig, dass ein solcher Nachbau der in den Karten eingesetzten Halbleiterchips möglichst erschwert ist. Dazu muss die Analyse des Chipaufbaus beziehungsweise der Schaltung und eine eventuelle Manipulation des Schaltverhaltens nach Möglichkeit verhindert werden. Außerdem ist es wichtig, dass an einem Terminal, an dem eine Chipkarte benutzt wird, die Echtheit der Chipkarte bzw. des darin integrierten Prozessors erkannt werden kann.

In der FR 2 580 834 ist eine Chipkarte beschrieben, bei der eine mit einem Mikroprozessor versehene integrierte Schaltung die zwischen Leiterbahnen auf der Oberseite vorhandenen ohmschen Widerstände, speziell eine damit gebildete Wheatstone-Brücke, auf Unversehrtheit überprüft. Bei festgestellter Unstimmigkeit wird die Funktion der Schaltung soweit außer Kraft gesetzt, dass sie nicht missbräuchlich verwendet werden kann, insbesondere nicht mit der Schaltung einer anderen Chipkarte ausgetauscht werden kann.

Aufgabe der vorliegenden Erfindung ist es, eine integrierte Schaltung mit einem Schutz gegen Analyse oder Eingriff, der nicht nach einer Manipulation ersetzt oder simuliert werden kann.

Diese Aufgabe wird mit dem Halbleiterbauelement mit den Merkmalen des Anspruches 1 bzw. mit dem Verfahren zur Herstellung eines Bauelementes mit den Merkmalen des Anspruches 15 oder 18 gelöst. Ausgestaltungen ergeben sich aus den abhängigen Ansprüchen.

Ein erfindungsgemäßes Halbleiterbauelement umfasst mindestens ein aktives Bauelement, insbesondere eine integrierte Schaltung, und eine auf das Halbleitermaterial aufgebrachte Schicht oder Schichtstruktur, die grundsätzlich einer herkömmlichen Verdrahtungsebene aus einem Dielektrikum und einer in Anteile strukturierten Leiterschicht, insbesondere einer Metallschicht, entspricht. Im Unterschied zu herkömmlichen Halbleiterchips ist bei dem erfindungsgemäßen Halbleiterbauelement mindestens ein ohmscher Widerstand vorgegebener Leitfähigkeit zwischen zwei Anteilen der Leiterschicht vorhanden, wobei diese Anteile der Leiterschicht so mit dem aktiven Bauelement oder der integrierten Schaltung verbunden sind, dass die Größe des ohmschen Widerstandes ermittelt werden kann, und/oder in oder auf der Schicht aus dem Dielektrikum ist ein Halbleiterbereich aus einem Material mit zumindest anteilig halbleitenden Eigenschaften vorhanden, wobei die Leiterschicht so in Bezug auf den Halbleiterbereich angebracht ist, dass in dem Halbleiterbereich eine Funktion eines aktiven Bauelementes und/oder eine Schaltfunktion durch Anlegen von elektrischen Spannungen an die Anteile der Leiterschicht ausgeführt werden kann.

Eine Ausführungsform mit einem zwischen den Anteilen der Leiterschicht vorhandenen ohmschen Widerstand ist vorzugsweise so ausgebildet, dass ein Widerstandsnetzwerk zwischen mehreren Anteilen der Leiterschicht vorhanden ist und diese Anteile der Leiterschicht so mit einer integrierten Schaltung in dem Halbleiterchip verbunden sind, dass charakteristische Eigenschaften des Widerstandsnetzwerkes ermittelt werden können. Auf diese Weise ist ein für den jeweiligen Chip charakteristisches Widerstandsnetzwerk vorhanden, das mit der integrierten Schaltung überprüft werden kann und anhand dessen die Unversehrtheit des Chips kontrolliert und/oder dessen Identität festgestellt werden kann. Ein Widerstandsnetzwerk sollte hierzu möglichst nichtlineare Widerstände aufweisen, um die Komplexität der Chip-Kennung zu erhöhen.

Bei einer anderen Ausführungsform des Halbleiterbauelementes ist auf einer Oberseite des Chips in oder auf einer Schicht aus einem Dielektrikum, insbesondere einem Intermetalldielektrikum zwischen den metallischen Verdrahtungsebenen, eine Struktur eines aktiven Bauelementes oder einer elektronischen Schaltung aufgebracht, womit eine Funktion eines aktiven Bauelementes und/oder eine Schaltfunktion durch Anlegen von elektrischen Spannungen ausgeführt werden kann. Das Halbleiterbauelement ist zu diesem Zweck mit einem Halbleiterbereich versehen, der in oder auf der Schicht aus einem Dielektrikum angeordnet ist, so dass er von dem Halbleitermaterial einer auf ein Substrat aufgebrachten Schichtstruktur oder eines Halbleiterkörpers vollständig getrennt ist.

Der Halbleiterbereich ist aus einem Material gebildet, das zumindest anteilig halbleitende Eigenschaften aufweist. Es kann sich dabei um ein Halbleitermaterial handeln, das vollständig oder zumindest bereichsweise elektrisch leitend dotiert ist, oder auch um ein Kunststoffmaterial, wie z. B. ein Polymer, das mit halbleitenden Eigenschaften zumindest bereichsweise versehen ist. Eine geeignet strukturierte Leiterschicht, z. B. eine Metallschicht, ist vorhanden, die so in Bezug auf den Halbleiterbereich angebracht ist, d. h. insbesondere in dessen Nähe angeordnet ist, dass in dem Halbleiterbereich durch Anlegen von elektrischen Spannungen an die Anteile der Leiterschicht eine Schaltfunktion ausgeführt werden kann. Vorzugsweise handelt es sich bei der durch den Halbleiterbereich und die Anteile der Leiterschicht gebildeten Struktur um eine Struktur eines als Schalter geeigneten Feldeffekttransistors.

Bei bevorzugten Ausführungsformen ist der Halbleiterbereich als Wanne in der Schicht aus Dielektrikum ausgebildet und die Leiterschicht auf einer Oberseite des Halbleiterbereiches aufgebracht. Bei anderen bevorzugten Ausgestaltungen ist der Halbleiterbereich auf einer von der Schicht aus Dielektrikum abgewandten Seite der strukturierten Leiterschicht angeordnet, wobei die Anteile der Leiterschicht vorzugsweise auf mehreren Seiten von dem Material des Halbleiterbereiches umgeben werden.

Ein auf dem Halbleiterchip angeordnetes Widerstandsnetzwerk oder eine aufgebrachte elektronische Schaltung kann als Schutzvorrichtung gegen unbefugtes Analysieren der integrierten Schaltung benutzt werden, was im Folgenden als Siegelbeschichtung bezeichnet wird. Eine solche Siegelbeschichtung wird vorzugsweise auf eine letzte als Verdrahtungsebene vorgesehene Metallschicht oder eine Isolatorabdeckung des Halbleiterchips aufgebracht. Über vertikale leitende Verbindungen (Kontaktlochfüllungen, Vias) ist die Siegelbeschichtung mit der in dem Halbleiterchip integrierten elektronischen Schaltung verbunden.

Sobald die Versorgungsspannung an den Halbleiterchip angelegt ist, kann die darin integrierte Schaltung das Vorhandensein der Siegelbeschichtung durch eine Art Messung überprüfen. Wenn festgestellt wird, dass die Siegelbeschichtung fehlt oder eine Antwort auf ein an die Siegelbeschichtung gesandtes Messsignal sich so wesentlich von einem erwarteten Echosignal unterscheidet, wird von einem unbefugten Eingriff in die Unversehrtheit des Chips ausgegangen. Die integrierte Schaltung kann dann z. B. bewirken, dass der Halbleiterchip unbrauchbar gemacht wird, dass wichtige Funktionen des Chips nicht mehr ausführbar sind und/oder dass der Inhalt eines in dem Chip integrierten Speichers gelöscht wird.

Da die Siegelbeschichtung über der Verdrahtung (z. B. aus Aluminium) liegt, muss bei einem Angriff auf den Chip die Siegelbeschichtung zuerst entfernt werden. Die Siegelbeschichtung ist daher so aufgebaut, dass das darin integrierte Widerstandsnetzwerk und die integrierte Schaltung nicht durch eine einfache Messung analysiert und durch Ersatzwiderstände bzw. eine Ersatzschaltung überbrückt werden können.

Die Siegelbeschichtung besteht daher vorzugsweise mindestens aus zwei Schichten, die sehr dünn sind (vorzugsweise dünner als 1 µm), jeweils verschiedene elektrische Funktionen erfüllen und nicht voneinander getrennt oder selektiv geätzt werden können. Die Schichten sollten möglichst aus gleichartigen Materialien bestehen, damit bei dem Versuch eines Abätzens der Schichtfolge durch chemische oder mechanische Verfahren nicht in einfacher Weise erkannt werden kann, wann genau jeweils eine Schicht entfernt ist. Wenn die oberste Schicht elektrisch isolierend ist, kann ein damit abgedecktes Widerstandsnetzwerk nicht einfach über eine Nadelkontaktierung ausgemessen werden.

Ein solches auf den Chip aufgebrachtes oder in einer tieferen Lage der Verdrahtungsebenen und Intermetalldielektrika integriertes Widerstandsnetzwerk zwischen den Anteilen der Metallschichten kann auch dazu verwendet werden, mittels eines Lesegerätes in einem Terminal (Endgerät, fest installiertem Benutzergerät) durch eine geeignete Messung zu überprüfen, ob ein echter Chip bzw. echter Prozessor verwendet wird. Die aus dem Widerstandsnetzwerk erhaltenen charakteristischen Messsignale werden mit den aus einem Speicher des Chips übermittelten, verschlüsselten Daten verglichen, was eine Chip-Kennung ermöglicht, die vergleichbar ist zu der Identifizierung von Geldscheinen anhand der Seriennummern. Das echte Widerstandsnetzwerk auf einem Halbleiterchip hält dazu bestimmte Gesetzmäßigkeiten ein, verfügt folglich über bestimmte Charakteristika, die von dem Terminal als echt akzeptiert werden.

Um einen mit dieser Ausführungsform eines erfindungsgemäßen Halbleiterbauelementes versehenen Chip nachbauen zu können, ist es erforderlich, das Widerstandsnetzwerk mit seinen Eigenschaften zu imitieren. Außerdem muss der Verschlüsselungscode bekannt sein, nach dem das Widerstandsnetzwerk auf seine Echtheit hin überprüft wird, da andernfalls die Chip-Kennung vom Lesegerät nicht akzeptiert wird. Für den Fall, dass es dennoch jemandem gelingt, den Verschlüsselungscode zu knacken und Halbleiterchips mit einem eigenen Widerstandsnetzwerk nachzubauen, kann eine weitere Sicherheitsstufe dadurch vorgesehen sein, dass von Chip zu Chip unterschiedliche Widerstandsnetzwerke verwendet werden. Die nachgebauten Chips müssen dann mit Widerstandsnetzwerken versehen werden, die bestimmte vorgegebene Abweichungen voneinander aufweisen. Die Lesegeräte einer Betreiberorganisation (z. B. einer Bank) können über eine statistische Auswertung der Chip-Kennungen feststellen, ob die Abweichungen der Widerstandsnetzwerke von Chip zu Chip den Vorgaben entsprechen oder eventuell abnormale Häufungen bestimmter Typen von Widerstandsnetzwerken auftreten. Wenn die einzelnen Chips untereinander nicht identisch sind, wird zudem erreicht, dass eine vollständige Analyse des Chipaufbaus nur sehr schwer aus den Ergebnissen von Untersuchungen mehrerer Chips gewonnen werden kann. Damit wird eine erhöhte Sicherheit insbesondere bei der Anwendung von Chipkarten erreicht. Falls eine wesentliche Abweichung von den Vorgaben festgestellt wird, kann der betreffende Chipkartentyp gesperrt werden und so von der Nutzung ausgeschlossen werden.

Das erfindungsgemäße Verfahren sieht vor, einen einlagigen oder mehrlagigen Film abzuscheiden und zu einem Widerstandsnetzwerk zu strukturieren, so dass ohmsche Widerstände vorgegebener Leitfähigkeiten zwischen je zwei dafür vorgesehenen Anteilen einer Leiterschicht vorhanden sind. Falls ein für eine Messung oder Schaltfunktion geeignetes Bauelement oder eine elektronische Schaltung im Bereich der Dielektrikumschichten zwischen den Verdrahtungsebenen vorgesehen ist, wird zusätzlich zu der Herstellung der für die Verdrahtung vorgesehenen strukturierten Leiterschichten mit dazwischen angeordneten Dielektrikumschichten ein Halbleiterbereich aus einem zumindest anteilig elektrisch leitenden Material in oder auf einer Schicht aus einem Dielektrikum ausgebildet und so mit einem oder mehreren Anteilen einer oder mehrerer Leiterschichten kontaktiert, dass die sich ergebende Struktur als aktives Bauelement, insbesondere als Schalttransistor, verwendet werden kann.

Auf diese Weise können aktive Bauelemente oder Schaltungskomponenten im Bereich der Verdrahtungsebenen, insbesondere einer obersten Metallschicht eines Halbleiterchips, ausgebildet werden. Damit ist es auch möglich, hochwirksame Sensoren für externe Bestrahlung, den Einfluss elektromagnetischer Felder und physikalische Eingriffe in die Unversehrtheit des Halbleiterchips zu realisieren. Ein solcher Sensor ist in einer Schichtlage ausgebildet, die eine unmittelbare Reaktion auf einen äußeren Einfluss ermöglicht, indem z. B. sofort ein elektrisches Signal generiert wird. Damit lassen sich insbesondere aktive Schutzschirme für sicherheitskritische Schaltungen realisieren. Diese aktiven Schutzschirme können auch in Verbindung mit dem zuvor beschriebenen Widerstandsnetzwerk eingesetzt werden.

Es folgte eine genauere Beschreibung von Beispielen des erfindungsgemäßen Bauelementes sowie des Herstellungsverfahrens anhand der beigefügten Figuren 1 bis 7.

Die Figuren 1 und 2 zeigen Zwischenprodukte nach verschiedenen Schritten eines Herstellungsverfahrens für ein erstes Ausführungsbeispiel im Querschnitt.

Die Figuren 3 bis 5 zeigen Zwischenprodukte eines Herstellungsverfahrens für ein weiteres bevorzugtes Ausführungsbeispiel im Querschnitt.

Die Figuren 6 und 7 zeigen alternative Ausführungsbeispiele im Querschnitt.

Die Figuren 8 bis 10 zeigen Ausführungsbeispiele erfindungsgemäßer Halbleiterbauelemente mit oberseitig angeordneten Sensoren im Schema.

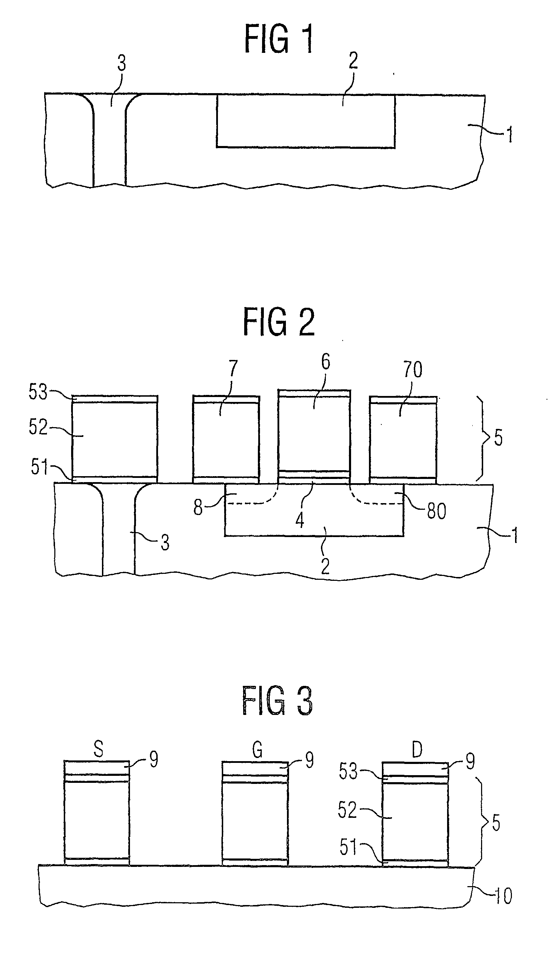

Zur genaueren Erläuterung der Erfindung sind in den Figuren 1 und 2 Querschnitte dargestellt, die einen Ausschnitt aus einem Bauelement nach verschiedenen Verfahrensschritten einer bevorzugten Ausführungsform der Erfindung zeigen. In der Figur 1 ist im Querschnitt ein Ausschnitt aus einer Schicht aus einem Dielektrikum 1 dargestellt, die eine Schicht der Verdrahtungsebene eines Halbleiterchips darstellt. Das Dielektrikum ist z. B. ein Zwischenmetalloxid, wie es an sich von der Herstellung mehrlagiger Verdrahtungsstrukturen bekannt ist. Zwischen diesen Zwischenmetalldielektrika sind die strukturierten Metallschichten angeordnet, in denen die für eine elektrische Verbindung der Anschlüsse der aktiven Bauelemente der elektronischen Schaltung vorgesehenen Leiterbahnen ausgebildet sind. Um die verschiedenen Verdrahtungsebenen miteinander verbinden zu können, werden während der Herstellung in den Zwischenmetalldielektrika senkrechte Löcher, so genannte Via-Holes, für Durchkontaktierungen mittels vertikaler elektrisch leitender Verbindungen hergestellt. In der Figur 1 ist zur Erläuterung der Besonderheiten des erfindungsgemäßen Verfahrens ein solches Kontaktloch 3 eingezeichnet, wie es von herkömmlichen Herstellungsverfahren für Halbleiterchips an sich bekannt ist.

Bei diesem Ausführungsbeispiel wird in dem Dielektrikum 1 außerdem eine Aussparung für den herzustellenden Halbleiterbereich 2 ausgeformt, was insbesondere durch Ausätzen des Dielektrikums geschehen kann. In die Aussparung wird ein Material eingebracht, das zumindest bereichsweise halbleitende Eigenschaften aufweist oder zumindest mit halbleitenden Eigenschaften versehen werden kann. Dieses Material kann bei bevorzugten Ausgestaltungen kristallines Silizium oder polykristallines Silizium sein, das elektrisch leitend dotiert wird oder zumindest in späteren Verfahrensschritten bereichsweise mit Dotierstoff elektrisch leitend gemacht wird.

Das Kontaktloch 3 kann in einer an sich bekannten Weise mit einer üblichen Kontaktlochfüllung, z. B. Wolfram, gefüllt werden. Bei dem erfindungsgemäßen Bauelement ist es statt dessen möglich, sowohl die für den Halbleiterbereich 2 vorgesehene Aussparung als auch die vertikalen Kontaktlöcher mit elektrisch leitendem Halbleitermaterial, insbesondere mit Silizium, zu füllen. Nach Bedarf kann die Oberfläche des Dielektrikums 1 anschließend eingeebnet werden, was z. B. mittels CMP (Chemical Mechanical Polishing) geschehen kann.

Erfindungsgemäß wird der damit hergestellte Bereich mit einem zumindest anteilig halbleitenden Material, im Folgenden und in den Ansprüchen als Halbleiterbereich bezeichnet, zur Ausbildung aktiver Bauelemente oder Komponenten verwendet. Vorzugsweise handelt es sich bei der Funktion des aktiven Bauelementes in dem Halbleiterbereich um eine Schaltfunktion, die durch eine Transistorstruktur bewirkt wird.

Zur Ausbildung einer Transistorstruktur wird in dem beschriebenen Beispiel gemäß Figur 2 zunächst ein Gate-Dielektrikum 4 auf einem Bereich der freien Oberfläche des Halbleiterbereiches aufgebracht. Daran anschließend wird eine Leiterschicht 5 abgeschieden und in Anteile strukturiert. Die Materialien dieser Leiterschicht 5 können mit den im Übrigen für Leiterbahnen und Kontakte verwendeten Materialien übereinstimmen. Diese Leiterschicht kann eine einzelne Schicht, z. B. aus Metall, sein oder eine mehrlagige Schicht, in der z. B. eine Barriereschicht 51, eine demgegenüber wesentlich dickere Metallschicht 52 und eine wiederum dünne Bedeckungsschicht 53 (top layer) übereinander angeordnet sind. Die Barriereschicht 51, die ein Ausdiffundieren des Metalls in das Halbleitermaterial ggf. verhindern soll, kann z. B. Titannitrid sein. Die Metallschicht 52 ist z. B. Aluminium oder Wolfram. Die Bedeckungsschicht 53, die unter anderem eine Korrosion verhindert, kann zum Beispiel WSi, TiSi, Ti oder TiN sein. Die genaue Ausgestaltung der Leiterschicht 5 ist aber nicht wesentlich für die Erfindung.

Die Leiterschicht 5 wird dann so strukturiert, dass Anteile gebildet werden, die in diesem Beispiel als Gate-Elektrode 6 und als Source-Anschluss 7 und Drain-Anschluss 70 vorgesehen sind. Die Gate-Elektrode 6 ist auf dem Gate-Dielektrikum 4 angeordnet. Der Source-Anschluss 7 und der Drain-Anschluss 70 bilden Kontakte direkt auf dem Material des Halbleiterbereiches 2. Zur Ausbildung des Source-Bereiches 8 und des Drain-Bereiches 80 in dem Halbleiterbereich 2 kann vor dem Aufbringen der Leiterschicht 5 noch Dotierstoff in diese Bereiche selbstjustiert bezüglich des Gate-Dielektrikums eingebracht werden. Dazu wird vorzugsweise dieselbe Maske verwendet, die auch zur Strukturierung des Gate-Dielektrikums 4 verwendet wird. Falls die Betriebseigenschaften (performance) des Transistors für die beabsichtigte Schaltfunktion ausreicht, kann das zusätzliche Einbringen von Dotierstoff an dieser Stelle aber entfallen.

Die in der Figur 2 dargestellte Struktur kann bei Anlegen elektrischer Spannungen an die Anteile der Leiterschicht 5 zum Auslösen von Schaltfunktionen verwendet werden. Unabhängig von der übrigen Struktur des Bauelementes, die grundsätzlich beliebig sein kann, kann in dem Halbleiterbereich 2 der Transistorstruktur der Figur 2 z. B. ein Sensor realisiert sein, mit dem jede physikalische Veränderung an der Oberseite des Bauelementes festgestellt werden kann. Falls in dem Beispiel der Figur 2 eine auf die Oberseite aufgebrachte Passivierung des Bauelementes entfernt wird und die Leitung der Gate-Elektrode 6, des Source-Anschlusses 7 oder des Drain-Anschlusses 70 durchtrennt wird, bewirkt die Änderung eine erkennbar fehlerhafte Schaltfunktion des Transistors.

Damit kann auch insbesondere ein sicherheitskritisches Signal, das als elektrische Spannung an der Gate-Elektrode 6 anliegt, zur Ausbildung eines aktiven Schutzschirmes (active shield guard) genutzt werden. Eine Änderung des sicherheitskritischen Signals bewirkt eine Änderung des Stromflusses zwischen Source und Drain in dem Kanal, die gemessen werden kann, um so die Änderung des Signals am Gate festzustellen. Dieses Bauelement ist daher zur Kontrolle sicherheitskritischer Signale in den obersten Schichtlagen eines Halbleiterchips geeignet.

Bei einem alternativen Ausführungsbeispiel wird der Halbleiterbereich auf der von der Schicht aus Dielektrikum abgewandten Seite der Leiterschicht angeordnet. In der Figur 3 ist wieder eine Schicht aus einem Dielektrikum 10 auf einer Oberseite eines Halbleiterchips dargestellt. Diese Schicht kann insbesondere ein Zwischenmetalldielektrikum der Verdrahtungsebenen sein. Bei diesem Ausführungsbeispiel ist auf diesem Dielektrikum 10 die Leiterschicht 5 aufgebracht und in verschiedene Anteile strukturiert. Vorzugsweise ist auf der Leiterschicht 5, die auch in diesem Beispiel eine Barriereschicht 51, eine Metallschicht 52 und eine Bedeckungsschicht 53 umfassen kann, eine für die eigentlichen Elektroden oder Kontakte vorgesehene Polysiliziumschicht 9 vorhanden. Diese Polysiliziumschicht 9 ist elektrisch leitend dotiert, z. B. für n-Leitung. Die Leiterschicht 5 und die Polysiliziumschicht 9 sind hier gemeinsam in Anteile strukturiert, die respektive für Source S, Gate G und Drain D vorgesehen sind.

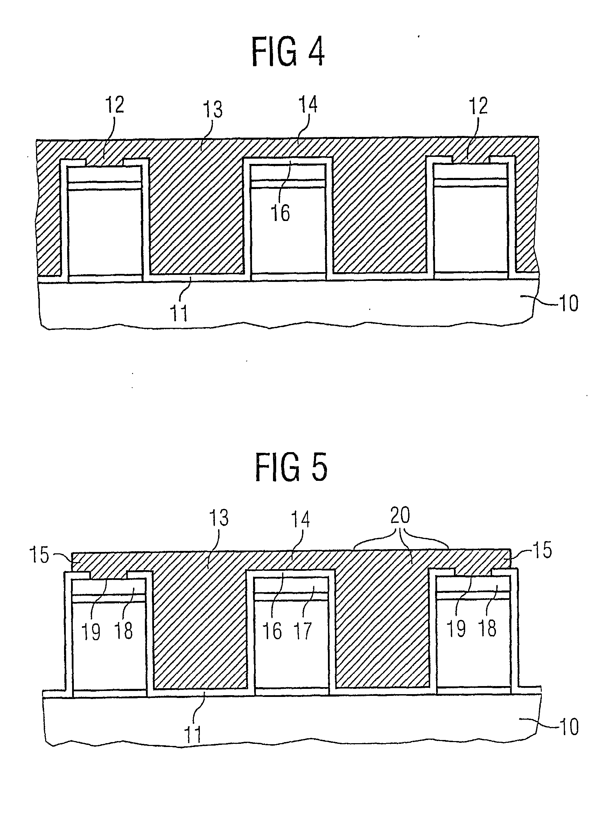

Wie in der Figur 4 im Querschnitt dargestellt ist, wird auf die Oberseite eine Dielektrikumschicht 11, vorzugsweise zunächst ganzflächig, aufgebracht. Diese Dielektrikumschicht 11 bedeckt daher die freien Oberseiten der Leiterschicht 5, der Polysiliziumschicht 9 und des Dielektrikums 10. Die Dielektrikumschicht 11 wird so strukturiert, dass auf dem für das Gate vorgesehenen Anteil der Leiterschicht und gegebenenfalls der Polysiliziumschicht ein Anteil der Dielektrikumschicht 11 als Gate-Dielektrikum 16 stehen bleibt.

Auf den für Source und Drain vorgesehenen Anteilen der Leiterschicht 5 bzw. der Polysiliziumschicht 9 wird zumindest ein so großer Anteil der Dielektrikumschicht 11 entfernt, wie für einen anschließend herzustellenden Source-Kontakt bzw. Drain-Kontakt erforderlich ist. In dem dargestellten Beispiel werden Fenster 12 in der Dielektrikumschicht 11 auf der Oberseite der für Source und Drain vorgesehenen Anteile der Polysiliziumschicht 9 hergestellt, was z. B. durch Ätzen unter Verwendung einer geeigneten Maske geschehen kann. Dann wird das Material 13, das für den Halbleiterbereich vorgesehen ist, ganzflächig so aufgebracht, dass die Leiterschicht 5 und die Polysiliziumschicht 9 bedeckt sind. Wesentlich ist dabei, dass über dem Gate-Dielektrikum 16 ein Anteil des Halbleiterbereiches als Kanalbereich 14 ausgebildet wird.

In der Figur 5 ist dargestellt, dass das aufgebrachte Material 13 des Halbleiterbereiches 20 an den Flanken 15 so weit entfernt ist, dass der Halbleiterbereich 20 auf den für das aktive Bauelement vorgesehenen Bereich begrenzt ist. Es ist jetzt eine Transistorstruktur vorhanden, bei der eine aus einem Anteil der Polysiliziumschicht gebildete Gate-Elektrode 17 durch das Gate-Dielektrikum 16 von dem in dem Halbleiterbereich 20 vorhandenen Kanalbereich 14 getrennt ist. Der Kanalbereich 14 ist mit Anteilen des Halbleiterbereiches verbunden, die Kontakte 19 mit den als Source-Kontakt und Drain-Kontakt 18 vorgesehenen Anteilen der Polysiliziumschicht bilden. Durch die seitliche Begrenzung des Halbleiterbereiches 20 ist es möglich, mehrere elektrisch voneinander isolierte aktive Bauelemente in der angegebenen Weise über der Schicht aus Dielektrikum 10 anzuordnen. Das in der Figur 5 dargestellte Bauelement ist wiederum geeignet, ein in der obersten Metalllage des Halbleiterchips geführtes Signal zum Schalten des Transistors zu verwenden und damit eine Sensorfunktion oder Sicherungsfunktion auszuüben.

Das bei anderen Ausführungsbeispielen des Halbleiterbauelementes vorhandene Widerstandsnetzwerk kann aus PECVD-Filmen (plasma enhanced chemical vapor deposition), Reactive-Sputter-Filmen (reaktives Aufstäuben) oder Polymer-Filmen ausgebildet sein. Die Leitfähigkeit der Filme kann über mehrere Größenordnungen verändert werden, indem die Abscheideparameter (Leistung, Druck, Self-bias, Gaszusammensetzung, Dotiergrad) verändert werden. Da die Abscheideanlagen in der Regel rechnergesteuert sind, können die Parameter entsprechend einer Fertigungsliste von Wafer zu Wafer ständig verändert werden. Damit erreicht man, dass sich die Chips von Wafer zu Wafer unterscheiden. Wenn das Layout des Widerstandsnetzwerkes über eine den Wafer abdeckende Lithographie-Maske von Chip zu Chip variiert wird, so wird sich jeder Chip vom anderen unterscheiden. Die Lage der Anschlusskontakte zum Widerstandsfilm oder die Geometrie des Widerstandsfilmes wird auf diese Weise von Chip zu Chip variiert und ggf. innerhalb einer vorgegebenen Auswahl permutiert.

Wenn das Widerstandsnetzwerk als Siegelbeschichtung auf dem Halbleiterchip aufgebracht ist und mit einer Isolatorschicht bedeckt ist, ist es von Vorteil, wenn sich das Material der leitfähigen Schicht bzw. der leitfähigen Schichten des Widerstandsnetzwerkes, insbesondere in der chemischen Zusammensetzung, nur geringfügig von dem Material der Isolatorschicht unterscheidet. Dadurch wird eine Analyse der Funktionsweise der Siegelbeschichtung erschwert. Bei Polymerfilmen ist insbesondere der Dotiergrad (Konzentration der Dotieratome) wesentlich. Das Ziel, die Leitfähigkeit der einzelnen Teilschichten über mehrere Größenordnungen zu variieren, kann wie erwähnt über die Abscheideparameter erreicht werden, so dass auf eine substanziellere Unterscheidung der Materialien verzichtet werden kann.

Als Material für das Widerstandsnetzwerk sind insbesondere mit Wasserstoff dotiertes amorphes Silizium (a-Si:H), Polysilizium, mit Wasserstoff dotierter amorpher Kohlenstoff (a-C:H), Titannitrid, Tantalnitrid, leitfähige Polymere (z. B. elektropolymerisiertes dotiertes Polythiophen oder durch Spin-Coating aufgebrachtes und dotiertes Polyanilin) und aufgedampfte organische Monomer-Filme (z. B. Pentazen) sowie Schichtfolgen aus diesen Materialien geeignet. Bevorzugt sind Materialien geeignet, deren Leitfähigkeit von dem vorhandenen elektromagnetischen Feld abhängt, insbesondere mit Wasserstoff dotiertes amorphes Silizium (a-Si:H), Polysilizium, mit Wasserstoff dotierter amorpher Kohlenstoff (a-C:H) und Schichtfolgen aus diesen Materialien. Silizium, Kohlenstoff und Nitride werden beispielsweise als PECVD-Filme abgeschieden; amorpher Kohlenstoff kann statt dessen aufgestäubt (sputter) werden.

Bei einem bevorzugten Ausführungsbeispiel mit einem Film aus a-C:H(:N) ist der Chip mit Kontakten versehen, die elektrisch leitend mit der Siegelbeschichtung verbunden sind. Die Kontakte dienen der Widerstandsmessung der Siegelbeschichtung. Sie sind in unregelmäßigen Abständen über die Chipoberfläche verteilt. Im Inneren des Chips können mehrere oder sogar alle Kontakte parallel geschaltet sein.

Ein Widerstandsfilm wird mittels eines PECVD-Verfahrens (plasma enhanced chemical vapor deposition) abgeschieden. Die dabei bevorzugten Bedingungen sind: kapazitive, parallele Plattenanordnung, Anoden-Kathoden-Flächenverhältnis von 4:1, 300 W HF-Leistung (bei einer zugelassenen Frequenz von 13,56 MHz), 0,2 mbar, 30°C Kathoden-Anfangstemperatur, Plasma aus Ethen und Stickstoff im Verhältnis 1:0,75. Am Anfang der Beschichtung (erste Lage) beträgt der Stickstoffanteil noch 0,05; nach ca. 15% der Beschichtungszeit wird die Stickstoffzufuhr voll zugeschaltet (zweite Lage). Die so erhaltene Doppelschicht weist eine Dicke von ca. 120 nm und bei geringer Feldstärke von weniger als 0,1 V/µm einen spezifischen Widerstand in lateraler Richtung von 10³ Ω cm und in vertikaler Richtung von 10⁵ Ω cm auf.

Darüber wird eine dritte Lage in einer Dicke von typisch ca. 200 nm aufgebracht, ohne dass das Vakuum gebrochen wird. Die dritte Lage unterscheidet sich von den ersten beiden Lagen lediglich dadurch, dass beim Aufbringen ein höherer Druck von 0,4 mbar eingestellt wird und im Precursor-Gas kein Stickstoff vorhanden ist. Die dritte Lage weist einen spezifischen Widerstand von typisch 6^{·}10⁸ Ω cm auf und dient als Isolator.

Auf diese Weise ist der Chip mit einer Siegelbeschichtung versehen, von der nach außen nur die isolierende a-C:H-Schicht erscheint, die keine direkte elektrische Messung erlaubt. Die Schicht ist so hart, dass sie von einer Testnadel nicht einfach durchstoßen werden kann. Die drei Lagen der Siegelbeschichtung können nicht voneinander abgezogen, also getrennt werden. Da die a-C:H-Schichten unmittelbar hintereinander abgeschieden werden, haften sie sehr gut aufeinander und sind durch Nassätzprozesse nicht selektiv voneinander zu trennen.

Auf den Kontaktflächen (pads) des Halbleiterchips wird die Schichtfolge, die sonst über eine Lackmaske aus Fotolack geschützt ist, durch reaktives Ionenätzen mit Sauerstoff entfernt, um einen elektrischen Anschluss (bonding) des Chips zu ermöglichen.

Um Temperatureffekte, die sich auf die Widerstände auswirken, zu kompensieren, ist auf dem Chip vorzugsweise ein Paar von Kontaktpunkten vorgesehen, das als Thermoelement dient, so dass die Schaltung des Chips eine temperaturbedingte Widerstandsdrift kompensieren kann.

Je nach der Größe der vorgesehenen Metallkontakte, die z. B. Aluminium mit einer Haftschicht aus Titan oder einer Titanverbindung sind, und ihrem Abstand zu dem Widerstandsfilm ergeben sich (bei einer elektrischen Feldstärke von mindestens 0,1 V/µm) bei Anlegen von elektrischen Spannungen zwischen Kontaktpunkten auf dem Chip Strom-Spannungskennlinien, die verschieden ausgeprägte Nichtlinearitäten und unterschiedliche Stromstärken zeigen. Die in dem Chip integrierte Schaltung misst den Strom bei mindestens zwei verschiedenen elektrischen Spannungen an denselben Kontakten, um die Nichtlinearität des dazwischen vorhandenen Widerstandes zu erfassen. Es sind entsprechende Komponenten der Schaltung vorzusehen, um diese Spannungen zur Verfügung zu stellen. Vorzugsweise werden die Widerstandsdaten im Chip gespeichert. Von außen lässt sich die Form der Strom-Spannungskennlinie nicht messtechnisch aufnehmen, auch wenn die oberste isolierende Schicht entfernt worden ist, da durch eine Kontaktierung nur der laterale Widerstand der niederohmigen Doppellage aus a-C:H:N gemessen werden könnte.

Die Schichtfolge der Siegelbeschichtung ist bei diesem Ausführungsbeispiel nicht strukturiert, wenn man von den Öffnungen zur Kontaktierung der Kontaktflächen der integrierten elektronischen Schaltung absieht. Die Siegelbeschichtung bedeckt daher im Wesentlichen die gesamte Oberseite des Chips. Wird die Siegelbeschichtung zumindest teilweise entfernt, ist dies in einer Widerstandsänderung zu bemerken, welche der Chip detektieren kann, sobald er unter Spannung gesetzt ist. Die in dem Chip integrierte Schaltung kann dann ggf. Verbindungen zerstören oder Speicherinhalte überschreiben, wenn eine Verletzung der Siegelbeschichtung festgestellt wird.

Bei einem weiteren Ausführungsbeispiel mit einem Film aus einem Polymer wird im Unterschied zu dem zuvor beschriebenen Ausführungsbeispiel als Siegelbeschichtung eine Schicht eines Polymers (z. B. Polyanilin) verwendet, die vorzugsweise durch Spin-Coating abgeschieden wird. Durch geeignete Dotierung dieser Schicht (Dotierstoffanteil unter 0,1% des Polymeranteils) kann der Widerstand der organischen Halbleiterschicht variiert werden. Polyanilin lässt sich mit Kampfersulfonsäure dotieren, die dem Polymer vor dem Spin-Coating zugesetzt wird. Vorzugsweise wird außerdem eine Fotobase zugesetzt, z. B. N-Methyl-2,6-dimethyl-3,5- (dicarbonsäurediethylester)-4-(o-nitrophenyl)-1,4-dihydropyridin. Durch ganzflächiges Belichten mit Licht niedriger Wellenlänge im ultravioletten Bereich wird erreicht, dass die Fotobase die Kampfersulfonsäure in einem oberen Anteil der Polymerschicht, der etwa 300 nm dick ist, neutralisiert. Dadurch wird die obere Schichtlage elektrisch isolierend, und nur noch der untere Teil der Schicht, der etwa 100 nm dick ist, bleibt leitfähig.

Wenn die Siegelbeschichtung in einer Fläche zwischen zwei Anschlusskontakten entfernt wird, ändert sich der Widerstand zwischen den Anschlusskontakten um einen rechnerisch zumindest näherungsweise bestimmbaren Wert. Das ist auch der Fall, wenn die Siegelbeschichtung mit Säuren behandelt wird, da sich dann die Leitfähigkeit der Siegelbeschichtung verändert. Die Änderung des Widerstandes kann von der Schaltung des Chips detektiert werden, sobald die Schaltung mit der Versorgungsspannung beaufschlagt ist. Es können dann die bereits beschriebenen Gegenmaßnahmen eingeleitet werden.

Auf die Oberseite eines Halbleiterchips, die mit einer Passivierungsschicht aus Oxid und/oder Nitrid versehen ist, wird im Allgemeinen eine Polymerschicht (hier auch als Pufferschicht bezeichnet) als Schutzschicht aufgebracht. Die dielektrische Polymerschicht kann fotosensitiv ausgebildet werden, um die Anschlusskontaktflächen besser freilegen zu können. Als dafür geeignete Materialien sind insbesondere Polymerbildungen auf der Basis von Polybenzoxazolen oder Polyimiden geeignet. Polymere können durch Einbau einer ausgedehnten π-Konjugation halbleitend ausgebildet werden. Eine halbleitende Polymerschicht kann von einer dielektrischen Polymerschicht spektroskopisch nicht unterschieden werden. Um eine Polymerschicht ausreichend halbleitend ausbilden zu können, genügt es, diese Schicht in einer Dicke von 50 nm bis 100 nm auszubilden. Die Pufferschicht kann daher so durch eine halbleitende Polymerschicht ergänzt werden, dass das Vorhandensein eines halbleitenden Anteils der Pufferschicht nur sehr schwer erkennbar ist. In der halbleitenden Polymerschicht können, wie bereits oben näher beschrieben wurde, Strukturen ausgebildet werden, die einem Feldeffekttransistor entsprechen und daher als Schalter eingesetzt werden können.

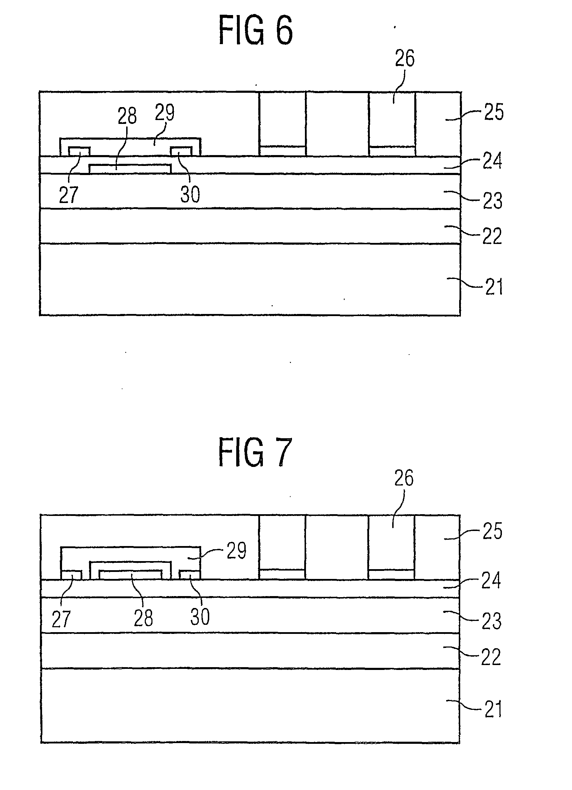

In der Figur 6 ist ein weiteres Ausführungsbeispiel des Halbleiterbauelementes im Querschnitt dargestellt. Ein Substrat 21 oder Halbleiterkörper mit den eigentlichen integrierten Schaltungen ist mit einer Verdrahtungsebene 22 versehen, deren Struktur von der integrierten Schaltung abhängt, im Übrigen an sich bekannt ist und daher in der Figur 6 nicht dargestellt ist. Die Verdrahtungsebene 22 umfasst üblicherweise eine oder mehrere Metallisierungsebenen, die zu den Leiterbahnen der elektrischen Verbindungen strukturiert und durch Zwischenmetalldielektrika hindurch miteinander verbunden sind. Als Beispiel für eine auf der Oberseite des Bauelementes aufgebrachte Passivierung sind in der Figur 6 eine erste Passivierungsschicht 23, die z. B. ein Oxid, insbesondere Siliziumoxid sein kann, und eine zweite Passivierungsschicht 24, die ein Nitrid, insbesondere Siliziumnitrid, sein kann, dargestellt. Darauf befindet sich eine an sich bekannte Pufferschicht 25 aus einem organischen Material, insbesondere einem Polymer. Darin sind Öffnungen für einen externen Anschluss der Metallkontakte 26 vorhanden. Diese Metallkontakte 26 sind mit der Verdrahtungsebene 22 über vertikale leitende Verbindungen elektrisch leitend verbunden, was an sich bekannt und hier im Einzelnen nicht dargestellt ist.

In der organischen Pufferschicht 25 ist zumindest eine Schichtlage zumindest bereichsweise halbleitend ausgebildet. Darin kann ein Bauelement angeordnet sein, das eine Funktion eines aktiven Bauelementes einer Schaltung besitzt. Z. B. kann ein einfacher Feldeffekttransistor vorhanden sein, der als Schalter verwendet werden kann, um anhand des Ansprechens dieses Transistors festzustellen, ob die Pufferschicht 25 intakt ist. In der Figur 6 ist ein solcher Feldeffekttransistor im Schema eingezeichnet. Auf der zweiten Passivierungsschicht 24 sind hier eine Source-Elektrode 27 und eine Drain-Elektrode 30 angeordnet. Diese Elektroden können ein Metall sein, das auch für die Kontakte 26 aufgebracht wird. Bei der Herstellung wird in diesem Fall auf die zweite Passivierung eine Metallisierung abgeschieden, die zu den Kontakten 26 und den Elektroden 27, 30 strukturiert wird.

Die für den Transistor vorgesehenen Elektroden 27, 30 sind in ein organisches Halbleitermaterial 29 eingebettet. Dieses organische Halbleitermaterial 29 ist hier ein Teil der Pufferschicht 25, die bereichsweise elektrisch leitend ausgebildet ist. Das organische Halbleitermaterial 29 bedeckt die Source-Elektrode 27 und die Drain-Elektrode 30 so, dass dort ein Source-Bereich und ein Drain-Bereich und ein dazwischen angeordneter Kanalbereich vorhanden sind. Auf der ersten Passivierungsschicht 23 und innerhalb der zweiten Passivierungsschicht 24 angeordnet befindet sich zu dem Zweck der Ansteuerung des Kanalbereiches eine Gate-Elektrode 28.

Ähnlich dem zuvor anhand Figur 5 beschriebenen Ausführungsbeispiel ist auch bei diesem Ausführungsbeispiel gemäß Figur 6 eine Transistorstruktur gebildet, bei der der Kanalbereich auf der von dem Substrat oder Halbleiterkörper abgewandten Seite der Gate-Elektrode angeordnet ist. Besonders zweckmäßig bei dem Ausführungsbeispiel gemäß Figur 6 ist, dass die ohnehin bei den üblichen Halbleiterchips hergestellte obere Passivierungsschicht, hier die zweite Passivierungsschicht 24, gleichzeitig als Gate-Dielektrikum zwischen dem Kanalbereich und der Gate-Elektrode verwendet wird.

In der Figur 7 ist ein weiteres Ausführungsbeispiel ähnlich dem Ausführungsbeispiel der Figur 6 dargestellt, bei dem auch die Gate-Elektrode 28 wie die Source-Elektrode 27 und die Drain-Elektrode 30 auf der zweiten Passivierungsschicht 24 angeordnet ist. Als Gate-Dielektrikum wird ein dielektrischer Anteil der Pufferschicht 25 verwendet, der typisch eine Dicke von etwa 100 nm bis 300 nm aufweist. Eine derartige Schichtenfolge in der Pufferschicht 25 gemäß Figur 7 ist leicht herstellbar. Dazu wird zunächst der dielektrische Anteil über der Gate-Elektrode 28 aufgebracht und strukturiert. Anschließend wird der halbleitende Anteil aufgebracht, der als organisches Halbleitermaterial 29 den Source-Bereich, den Drain-Bereich und den Kanalbereich des Transistors bildet. Danach kann die Pufferschicht 25 vervollständigt werden, indem erneut ein dielektrischer Anteil des Materials bis zu der vorgesehenen Gesamtdicke der Pufferschicht 25 planarisierend aufgebracht wird.

Bei dem erfindungsgemäßen Halbleiterchip kann ein Widerstandsnetzwerk in einer im Prinzip beliebigen Schichtlage oberhalb des Halbleitermaterials integriert sein, um so ein Mittel zur Chip-Kennung bereitzustellen. Der Chip ist für diese Anwendung mit Kontaktpunkten versehen, die mittels elektrisch leitender Verbindungen zu Anschlusskontaktflächen eines Chipträgers, z. B. einer Chipkarte, geführt werden. Diese Anschlusskontaktflächen dienen der Datenübertragung zwischen dem Chip und einem Terminal, z. B. einem Lesegerät. Zu den ohnehin vorhandenen Anschlusskontaktflächen, die für die Datenübertragung und/oder Energieübertragung vorgesehen sind, kommen bei diesem Ausführungsbeispiel mindestens zwei zusätzliche Anschlusskontakte hinzu. In den Fällen, in denen die Werte der ohmschen Widerstände des Widerstandnetzwerkes hoch genug sind, können die ohnehin vorgesehenen Anschlusskontaktflächen auch für die Bestimmung dieser Widerstände benutzt werden, da in diesen Fällen kein Kurzschluss zwischen den Anschlusskontaktflächen auftritt. In der Verdrahtung der in dem Chip integrierten Schaltung werden vier oder mehr Kontaktpunkte miteinander durch Leitbahnen (z. B. metallische Leiterbahnen) und Bahnen aus dem Film bzw. der Schicht des Widerstandsnetzwerkes verbunden. Im Fall von vier für eine Verbindung mit dem Lesegerät vorgesehenen Kontakten sind das 3! = 6 Verbindungen.

Bei diesem Ausführungsbeispiel des Halbleiterbauelementes mit einem Widerstandsnetzwerk zur Chip-Kennung kann das Widerstandsnetzwerk über ein PECVD-Verfahren hergestellt werden, wobei ein geeignetes Plasma Ethen und Stickstoff mit variablem Stickstoffanteil enthält. Die Bedingungen sind: kapazitive, parallele Plattenanordnung, ein Anoden-Kathoden-Flächenverhältnis von 4:1, 300 W HF-Leistung (bei einer zugelassenen Frequenz von 13,56 MHz), ein Druck von 0,2 mbar, 30°C Kathoden-Anfangstemperatur. Je nach Stickstoffanteil (0 bis 70%) erhält man Schichten mit einer Dicke von ca. 100 nm und einem spezifischen Widerstand von 10⁸ bis 10² Ω cm bei einer elektrischen Feldstärke von weniger als 0,1 V/µm, wenn als Material amorpher Kohlenstoff (a-C:H:N) abgeschieden wird.

Mittels einer Fototechnik wird die Widerstandsschicht strukturiert, so dass zum einen die Anschlusskontaktflächen freigelegt sind und zum anderen für jeden Chip auf dem Wafer anders strukturierte Leitbahnen in der Widerstandsschicht zwischen den Kontaktpunkten entstehen. Je nach der Größe der Metallkontakte (beispielsweise Aluminium mit Titan-Haftschicht) und ihrem Abstand zum Widerstandsfilm sowie der Länge, Breite und Dicke der Bahnen aus dem Widerstandsfilm und der spezifischen feldabhängigen Leitfähigkeit des Materials des Widerstandsfilms (bei Feldstärken oberhalb von 0,1 V/µm) ergeben sich für elektrische Spannungen zwischen Kontakten auf dem Chip Strom-Spannungskennlinien mit verschieden ausgeprägter Nichtlinearität und unterschiedlichen Stromstärken als Funktion der Spannung.

Auch hier kann auf dem Chip ein Thermoelement vorgesehen sein, um Temperatureffekte auf den Widerstand zu kompensieren. Vorzugsweise wird in dem Lesegerät eine temperaturbedingte Widerstandsdrift rechnerisch eliminiert, bevor die Messdaten der einzelnen Widerstandsbahnen mit den abgespeicherten Kenndaten des Chips verglichen werden. Es ist damit erreicht, dass die einzelnen Halbleiterchips individuelle Kenndaten besitzen, die von einem Terminal auf einfache Weise überprüft werden können.

Bei einem alternativen Ausführungsbeispiel einer solchen Ausgestaltung des erfindungsgemäßen Halbleiterchips zur einfachen Chip-Kennung wird der Film des Widerstandsnetzwerkes aus amorphem Kohlestoff ohne eingebrachten Stickstoff (a-C:H) hergestellt. Es wird hier ein Plasma aus Methan mit variabler HF-Leistung verwendet. Je nach Leistung (200 bis 500 W) erhält man Schichten mit einer Dicke von typisch etwa 100 nm und einem spezifischem Widerstand von 10⁴ bis 10¹ Ω cm bei geringer elektrischer Feldstärke unterhalb von 0,1 V/µm.

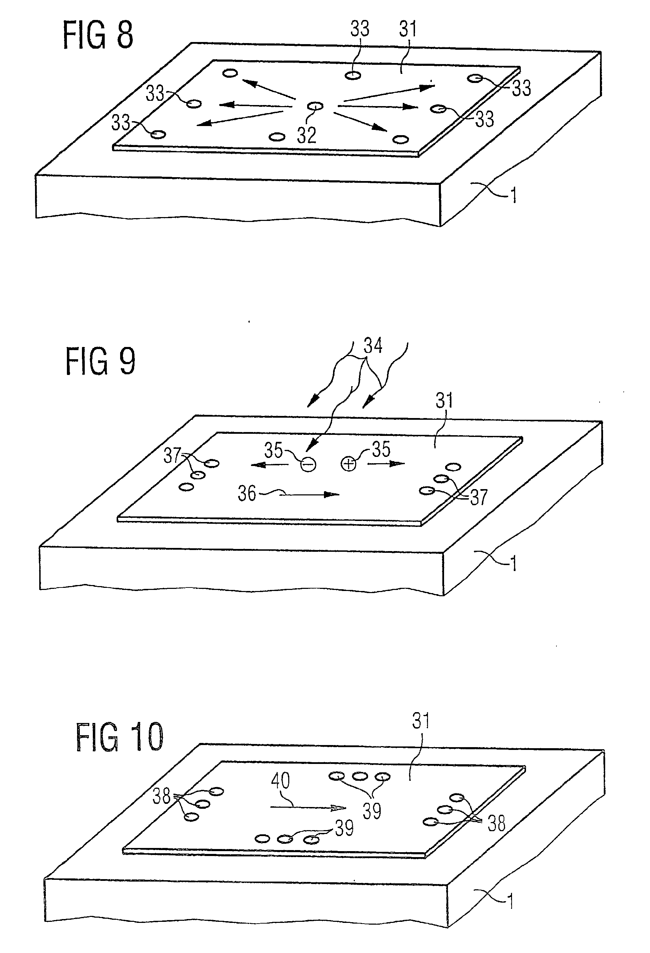

In der Figur 8 ist ein erfindungsgemäßes Halbleiterbauelement mit einem auf der Oberseite aufgebrachten Depassivierungssensor dargestellt. Auf einem Dielektrikum 1 ist eine halbleitende Schicht 31, z. B. aus Silizium, als Halbleiterbereich (nicht notwendig ganzflächig) aufgebracht und mit elektrischen Kontakten als Anteilen einer Leiterschicht versehen. Die Kontakte werden von der halbleitenden Schicht 31 überdeckt, in der vertikale Durchkontaktierungen (so genannte Vias) zu den Kontakten vorgesehen sein können. Der in der Mitte eingezeichnete Kontakt ist hier als Source-Kontakt 32, die übrigen Kontakte sind als Drain-Kontakte 33 vorgesehen. Es können auch mehrere Source-Kontakte vorgesehen sein. Die zwischen den Kontakten vorhandenen Bereiche der halbleitenden Schicht 31 sind als Kanalbereiche vorgesehen, die ähnlich wie bei einem Ausführungsbeispiel gemäß den Figuren 5, 6 oder 7 von der Unterseite, d. h. von derjenigen Seite der halbleitenden Schicht, auf der das Dielektrikum 1 vorhanden ist, mittels dort jeweils angeordneter Gate-Elektroden angesteuert werden können. Die Gate-Elektroden können aber auch weggelassen sein, so dass die Strecken zwischen den Kontakten als ohmsche Widerstände fungieren.

Bei der Herstellung wird die halbleitende Schicht 31 inhomogen abgeschieden (so genannte "dusty deposition"), so dass die elektrischen Widerstände in der halbleitenden Schicht zwischen dem Source-Kontakt 32 und je einem Drain-Kontakt 33 in den Richtungen der eingezeichneten Pfeile zufällig erzeugte unterschiedliche Werte besitzen und auf diese Weise ein Widerstandsnetzwerk ausgebildet ist. Die Werte der Widerstände sind bei dieser Herstellung für die Chips auch auf demselben Wafer verschieden. Durch eine Messung der einzelnen Widerstände kann eine Chip-Kennung ermittelt werden, die in dem Chip abgespeichert werden kann. Wenn die halbleitende Schicht beschädigt, teilweise abgetragen oder entfernt wird, ändern sich die Widerstandswerte. Wenn die in dem Chip integrierte Schaltung eine Änderung der messtechnisch kontrollierten Widerstandswerte feststellt, kann von einem Angriff zur Analyse des Chipaufbaus ausgegangen und eine entsprechend vorgesehene Gegenmaßnahme eingeleitet werden.

In der Figur 9 ist ein erfindungsgemäßes Halbleiterbauelement mit einem auf der Oberseite aufgebrachten Lichtsensor dargestellt. Auf einem Dielektrikum 1 ist eine halbleitende Schicht 31, z. B. aus Silizium, als Halbleiterbereich oder Teil des Halbleiterbereiches (nicht notwendig ganzflächig) aufgebracht. Ein pn-Übergang befindet sich zwischen vorzugsweise in der halbleitenden Schicht 31 ausgebildeten dotierten Bereichen einander entgegengesetzter Leitfähigkeitstypen, die mit elektrischen Anschlüssen an die Verdrahtungsebenen des Chips oder direkt an Komponenten einer integrierten Schaltung versehen sind. Die elektrischen Anschlüsse sind vorzugsweise durch Kontakte 37 an den in der Figur 9 als Beispiel eingezeichneten Positionen gebildet und werden von der halbleitenden Schicht 31 überdeckt, in der vertikale Durchkontaktierungen (so genannte Vias) zu den Kontakten vorgesehen sein können. Mit dieser Ausführungsform ist demnach eine Art Fotodiode ausgebildet.

Bei Lichteinfall 34 in den Halbleiterbereich werden Ladungsträger 35 im Bereich des pn-Überganges getrennt, die bei Anliegen einer elektrischen Spannung in der Sperrrichtung einen Strom 36 hervorrufen. Dieser Fotostrom wird gemessen oder zumindest detektiert, womit auf eine Bestrahlung des Bauelementes geschlossen werden kann. Wenn die in dem Chip integrierte Schaltung einen Fotostrom ungewöhnlicher Stärke registriert, kann von einem Angriff zur Analyse des Chipaufbaus ausgegangen und eine entsprechend vorgesehene Gegenmaßnahme eingeleitet werden.

In der Figur 10 ist ein erfindungsgemäßes Halbleiterbauelement mit einem auf der Oberseite aufgebrachten Hallsensor zur Detektion von Magnetfeldern dargestellt. Auf einem Dielektrikum 1 ist eine halbleitende Schicht 31, z. B. aus Silizium, als Halbleiterbereich oder Teil des Halbleiterbereiches (nicht notwendig ganzflächig) aufgebracht und mit elektrischen Anschlüssen an die Verdrahtungsebenen des Chips oder direkt an Komponenten einer integrierten Schaltung versehen. Die elektrischen Anschlüsse sind vorzugsweise durch Kontakte 38 an halbleitendem Material gleichen Vorzeichens der Leitfähigkeit an den in der Figur 10 als Beispiel eingezeichneten, in einem Abstand zueinander angeordneten Positionen gebildet und werden von der halbleitenden Schicht 31 überdeckt, in der vertikale Durchkontaktierungen (so genannte Vias) zu den Kontakten vorgesehen sein können. Zwischen den Kontakten 38 sind seitlich versetzt weitere Kontakte 39 angeordnet.

Durch Anlegen einer elektrischen Spannung zwischen den ersten Kontakten 38 kann ein Stromfluss in der Richtung des eingezeichneten Pfeiles 40 hervorgerufen werden. Die sich bewegenden Ladungsträger werden in einem senkrecht zu der Ebene der halbleitenden Schicht 31 orientierten Magnetfeld durch die auftretende Lorentz-Kraft gemäß der Lenzschen Regel innerhalb der Schichtebene aus ihrer geradlinigen Bahn abgelenkt. Dadurch kommt es beidseitig quer zu der Stromrichtung zu Konzentrationen von Ladungsträgern einander entgegengesetzter Vorzeichen. An den seitlich angeordneten weiteren Kontakten 39 kann daher bei einem Auftreten eines äußeren Magnetfeldes, das senkrecht zu der Schichtebene ausgerichtet ist, eine Spannung abgegriffen werden. Damit kann das äußere Magnetfeld nachgewiesen werden. Wenn die in dem Chip integrierte Schaltung ein Magnetfeld ungewöhnlicher Stärke registriert, kann von einem Angriff zur Analyse des Chipaufbaus ausgegangen und eine entsprechend vorgesehene Gegenmaßnahme eingeleitet werden.

Der Halbleiterbereich, insbesondere in Gestalt der halbleitenden Schicht 31 gemäß den Ausführungsbeispielen der Figuren 8 bis 10, kann bei jedem der beschriebenen Ausführungsbeispiele sowie bei den sich daraus ergebenden Abwandlungen und weiteren Ausgestaltungen, die im Rahmen der Erfindung liegen, auch verwendet werden, um ein äußeres elektrisches Feld zu detektieren, das eine elektrische Potenzialdifferenz in dem halbleitenden Material hervorruft, die als elektrische Spannung an den Kontakten abgegriffen werden kann.

### Bezugszeichenliste

- 1: Dielektrikum
- 2: Halbleiterbereich
- 3: Kontaktloch
- 4: Gate-Dielektrikum
- 5: Leiterschicht
- 6: Gate-Elektrode
- 7: Source-Anschluss
- 8: Source-Bereich
- 9: Polysiliziumschicht
- 10: Dielektrikum
- 11: Dielektrikumschicht
- 12: Fenster
- 13: Material
- 14: Kanalbereich
- 15: Flanke
- 16: Gate-Dielektrikum
- 17: Gate-Elektrode
- 18: Source-Kontakt und Drain-Kontakt
- 19: Kontakt
- 20: Halbleiterbereich
- 21: Substrat
- 22: Verdrahtungsebene
- 23: erste Passivierungsschicht
- 24: zweite Passivierungsschicht
- 25: Pufferschicht
- 26: Metallkontakt
- 27: Source-Elektrode
- 28: Gate-Elektrode
- 29: organisches Halbleitermaterial
- 30: Drain-Elektrode
- 31: halbleitende Schicht
- 32: Source-Kontakt
- 33: Drain-Kontakt
- 34: Lichteinfall
- 35: Ladungsträger
- 36: Strom
- 37: Kontakt
- 38: Kontakt
- 39: weiterer Kontakt
- 40: Pfeil
- 52: Metallschicht
- 53: Bedeckungsschicht
- 70: Drain-Anschluss
- 80: Drain-Bereich

## Patentansprüche

1. Halbleiterbauelement mit
einem aktiven Bauelement oder einer integrierten Schaltung und
einer darauf aufgebrachten Schicht oder Schichtstruktur, die mindestens eine Schicht aus einem Dielektrikum und mindestens eine in Anteile strukturierte Leiterschicht umfasst,
**dadurch gekennzeichnet, dass** mindestens eine Anordnung aus der Gruppe von
- mehrlagigem Widerstandsnetzwerk,
- einem für einen jeweiligen Chip charakteristischen Widerstandsnetzwerk,
- einem durch unterschiedliche Konzentrationen von Dotieratomen in einem Polymerfilm ausgebildeten Widerstandsnetzwerk und
- einem Halbleiterbereich (2; 20; 29), der in einem Material mit zumindest anteilig halbleitenden Eigenschaften in oder auf der Schicht aus dem Dielektrikum (1; 10; 25) ausgebildet ist und in dem auf Grund der Anordnung der Leiterschicht (5) eine Funktion eines aktiven Bauelementes
und/oder eine Schaltfunktion ausgeführt werden kann, vorhanden und so angeschlossen ist, dass mindestens eine elektrische Eigenschaft der Anordnung in einer vorgegebenen Weise überprüft werden kann.

2. Halbleiterbauelement nach Anspruch 1, bei dem
ein strukturierter Film als Widerstandsnetzwerk zwischen mehreren Anteilen der Leiterschicht vorhanden ist.

3. Halbleiterbauelement nach Anspruch 2, bei dem
das Widerstandsnetzwerk ein einlagiger oder mehrlagiger Film aus mindestens einem Material aus der Gruppe von a-Si:H, Polysilizium, a-C:H, a-C:H:N, Titannitrid, Tantalnitrid, elektrisch leitfähigem Polymer und organischem Monomer ist.

4. Halbleiterbauelement nach Anspruch 1, bei dem
der Halbleiterbereich eine halbleitende Schicht (31) ist und die Anteile der Leiterschicht als Kontakte (32, 33; 37; 38, 39) elektrisch leitend mit der halbleitenden Schicht verbunden sind.

5. Halbleiterbauelement nach Anspruch 4, bei dem
die halbleitende Schicht (31) mit den Kontakten (32, 33) als Widerstandsnetzwerk ausgebildet ist und
die Kontakte so mit der integrierten Schaltung verbunden sind, dass charakteristische Eigenschaften des Widerstandsnetzwerkes ermittelt werden können.

6. Halbleiterbauelement nach Anspruch 4, bei dem
durch den Halbleiterbereich (2; 20) und die Anteile der Leiterschicht (5) eine Struktur eines als Schalter geeigneten Feldeffekttransistors ausgebildet ist.

7. Halbleiterbauelement nach Anspruch 4, bei dem
die halbleitende Schicht (31) mit den Kontakten (37) als Fotodiode ausgebildet ist, so dass bei einer Bestrahlung des Halbleiterbauelementes ein Fotostrom zwischen den Kontakten abgegriffen werden kann.

8. Halbleiterbauelement nach Anspruch 4, bei dem
die Kontakte (38, 39) so angeordnet sind, dass ein Stromfluss in der halbleitenden Schicht hervorgerufen werden kann und eine Hallspannung, die infolge eines äußeren Magnetfeldes auftritt, an den Kontakten abgegriffen werden kann.

9. Halbleiterbauelement nach Anspruch 6, bei dem
ein Halbleiterbereich (2) in der Schicht aus dem Dielektrikum (1) angeordnet ist, so dass ein Anteil des darin vorhandenen Materials eine von dem Dielektrikum freie Oberfläche aufweist und
auf diese Oberfläche bereichsweise ein Gate-Dielektrikum (4) aufgebracht ist, das mit einem Anteil der Leiterschicht (5) als Gate-Elektrode (6) versehen ist.

10. Halbleiterbauelement nach Anspruch 9, bei dem
in dem Material des Halbleiterbereiches (2) seitlich zu dem Gate-Dielektrikum Source- und Drain-Bereiche (8, 80) durch Einbringen von Dotierstoff ausgebildet und mit je einem Anteil der Leiterschicht (5) als Source-Anschluss (7) bzw. Drain-Anschluss (70) versehen sind.

11. Halbleiterbauelement nach Anspruch 6, bei dem
Anteile der Leiterschicht (5) zwischen der Schicht aus dem Dielektrikum (10) und dem Halbleiterbereich (20) angeordnet sind.

12. Halbleiterbauelement nach Anspruch 11, bei dem
zwischen einem Anteil der Leiterschicht (5) und dem Material des Halbleiterbereiches (20) eine Dielektrikumschicht (11) als Gate-Dielektrikum (16) vorhanden ist und
ein an das Gate-Dielektrikum (16) angrenzender Anteil des Halbleiterbereiches (20) als Kanalbereich (14) eines Transistors vorgesehen ist.

13. Halbleiterbauelement nach Anspruch 6, bei dem
der Halbleiterbereich (29) aus organischem Material in der Schicht aus dem Dielektrikum (25) über einer Passivierungsschicht (24) angeordnet ist,
auf der von dem Halbleiterbereich (29) abgewandten Seite der Passivierungsschicht (24) eine Gate-Elektrode (28) und auf der dem Halbleiterbereich (29) zugewandten Seite der Passivierungsschicht (24) eine Source-Elektrode (27) und eine Drain-Elektrode (30) als Anteile der Leiterschicht angeordnet sind.

14. Halbleiterbauelement nach Anspruch 6, bei dem
der Halbleiterbereich (29) aus organischem Material in der Schicht aus dem Dielektrikum (25) über einer Passivierungsschicht (24) angeordnet ist,
auf der dem Halbleiterbereich (29) zugewandten Seite der Passivierungsschicht (24) eine Gate-Elektrode (28), eine Source-Elektrode (27) und eine Drain-Elektrode (30) als Anteile der Leiterschicht angeordnet sind und
zwischen der Gate-Elektrode (28) und dem Halbleiterbereich (29) ein Anteil des Dielektrikums (25) als Gate-Dielektrikum vorhanden ist.

15. Verfahren zur Herstellung eines Bauelementes, bei dem
ein aktives Bauelement oder eine integrierte Schaltung in einem Substrat oder Halbleiterkörper oder einer Halbleiterschichtstruktur hergestellt wird und
durch dielektrisches Material davon elektrisch isoliert mindestens eine in Anteile strukturierte Leiterschicht hergestellt wird,
**dadurch gekennzeichnet, dass**
ein einlagiger oder mehrlagiger Film abgeschieden und zu einem Widerstandsnetzwerk strukturiert wird, so dass ohmsche Widerstände vorgegebener Leitfähigkeiten zwischen je zwei dafür vorgesehenen Anteilen der Leiterschicht vorhanden sind.

16. Verfahren nach Anspruch 15, bei dem
der Film hergestellt wird in einem Verfahrensschritt aus der Gruppe von
Abscheiden von a-Si:H, Polysilizium, a-C:H, a-C:H:N, Titannitrid oder Tantalnitrid mittels CVD oder PECVD,
Abscheiden von a-C:H oder a-C:H:N mittels Aufstäubens, Abscheiden und Dotieren von Polymer und
Aufdampfen von organischem Monomer.

17. Verfahren nach Anspruch 16, bei dem
der Film mit mindestens einem Material aus der Gruppe von elektropolymerisiertem und dotiertem Polythiophen, durch Spin-Coating aufgebrachtem und dotiertem Polyanilin und/oder aufgedampftem Pentazen hergestellt wird.

18. Verfahren zur Herstellung eines Bauelementes, bei dem ein aktives Bauelement oder eine integrierte Schaltung in einem Substrat oder Halbleiterkörper oder einer Halbleiterschichtstruktur hergestellt wird und
eine Schicht oder Schichtstruktur darauf aufgebracht wird, die mindestens eine Schicht aus einem Dielektrikum (1, 10) umfasst,
**dadurch gekennzeichnet, dass**
in oder auf der Schicht aus dem Dielektrikum (1, 10) ein Halbleiterbereich (2, 20) aus einem Material mit zumindest anteilig halbleitenden Eigenschaften hergestellt wird und mindestens eine Leiterschicht (5) so in Bezug auf den Halbleiterbereich (2, 20) angebracht und in Anteile strukturiert wird, dass in dem Halbleiterbereich eine Funktion eines aktiven Bauelementes und/oder eine Schaltfunktion ausgeführt werden kann.

19. Verfahren nach Anspruch 18, bei dem
der Halbleiterbereich (2) und die Leiterschicht (5) hergestellt werden, indem
in einem ersten Schritt eine Aussparung in der Schicht aus dem Dielektrikum (1) hergestellt und mit einem für den Halbleiterbereich vorgesehenen Material gefüllt wird,
in einem zweiten Schritt auf einen oberseitigen Bereich dieses Materials eine Dielektrikumschicht als Gate-Dielektrikum (4) hergestellt wird,
in einem dritten Schritt eine Leiterschicht (5) abgeschieden und strukturiert wird, so dass mindestens ein Anteil auf dem Gate-Dielektrikum (4) und je ein Anteil seitlich dazu auf einander gegenüberliegenden Seiten auf dem für den Halbleiterbereich vorgesehenen Material gebildet werden.

20. Verfahren nach Anspruch 19, bei dem
zwischen dem zweiten Schritt und dem dritten Schritt selbstjustiert zu dem Gate-Dielektrikum (4) ein Dotierstoff zur Ausbildung von Source- und Drain-Bereichen (8, 80) in den Halbleiterbereich (2) eingebracht wird.

21. Verfahren nach Anspruch 18, bei dem
der Halbleiterbereich (20) und die Leiterschicht (5) hergestellt werden, indem
in einem ersten Schritt eine Leiterschicht (5) abgeschieden und so strukturiert wird, dass mindestens Anteile gebildet werden, die für eine Gate-Elektrode, einen Source-Anschluss und einen Drain-Anschluss vorgesehen sind,
in einem zweiten Schritt eine Dielektrikumschicht (11) abgeschieden und so strukturiert wird, dass auf dem für die Gate-Elektrode vorgesehenen Anteil der Leiterschicht (5) ein Gate-Dielektrikum (16) gebildet wird und jeweils ein Bereich einer Oberfläche der für den Source-Anschluss und den Drain-Anschluss vorgesehenen Anteile der Leiterschicht frei bleibt, und
in einem dritten Schritt ein für den Halbleiterbereich (20) vorgesehenes Material so aufgebracht wird, dass ein Anteil davon über dem Gate-Dielektrikum (16) als Kanalbereich (14) vorgesehen wird und damit zusammenhängende Anteile des Halbleiterbereiches mit den frei gebliebenen Oberflächen der für den Source-Anschluss und den Drain-Anschluss vorgesehenen Anteile der Leiterschicht verbunden sind.

22. Verfahren nach Anspruch 21, bei dem
in dem ersten Schritt auf die Leiterschicht (5) eine elektrisch leitend dotierte Polysiliziumschicht (9) abgeschieden und zusammen mit der Leiterschicht strukturiert wird.
